# EUROPÄISCHE PATENTANMELDUNG

(11) **EP 0 851 477 A2**
(43) Veröffentlichungstag der Anmeldung: **01.07.1998**
(21) Anmeldenummer: 97440136.6
(22) Anmeldetag: 17.12.1997
(51) Int. Cl.: H01L 21/66

(54) **Verfahren zur Kontrolle der Genauigkeit beim mehrstufigen Ätzen**

(30) Priorität: 19.12.1996 DE 19652974
(71) Anmelder: ALCATEL ALSTHOM COMPAGNIE GENERALE D'ELECTRICITE, 75008 Paris (FR)
(72) Erfinder: Hehmann, Jörg, 70499 Stuttgart (DE)
(74) Vertreter: Knecht, Ulrich Karl, Dipl.-Ing.

(57) **Zusammenfassung**

Es ist ein Verfahren zur Kontrolle der Genauigkeit des Bearbeitungsergebnisses bei der Herstellung von Vertiefungen in einem Substrat durch mehrstufiges Ätzen angegeben. Die Kontrolle ist auf einfache Weise dadurch möglich, daß auf den Ätzmasken Strichmuster angebracht sind. Die Strichmuster auf den Ätzmasken für verschiedene Ätzstufen sind verschieden und bilden ein Noniussystem.

## Beschreibung

Die Erfindung betrifft ein Verfahren zur Kontrolle der Genauigkeit des Bearbeitungsergebnisses bei der Herstellung von Vertiefungen in einem Substrat durch mehrstufiges Ätzen.

Bauelemente, welche hochpräzise Mikrostrukturen aufweisen, werden durch Ätzen hergestellt. Dazu ist es erforderlich, daß sie nach einem photolitho-graphischen Verfahren mit Ätzmasken versehen werden. Wenn die Mikrostrukturen eine komplizierte Gestalt aufweisen, d.h. sie unterschiedliche Strukturtiefen aufweisen, und außerdem noch ineinander verschachtelt sind, dann sind zwei oder mehrere Ätzvorgänge durchzuführen.

Da die Ergebnisse der verschiedenen Ätzvorgänge eine genaue Lage zueinander aufweisen müssen, ist es erforderlich, die verschiedenen Ätzmasken ebenfalls genau zueinander zu justieren, wozu entsprechende Apparaturen zur Verfügung stehen. Es ist ebenfalls notwendig, das Ergebnis des mehrstufigen Ätzvorganges nach Fertigstellung der Mikrostruktur auf seine Genauigkeit überprüfen zu können.

Das der Erfindung zugrunde liegende technische Problem besteht darin, ein Mittel anzugeben, mit dem auf einfache Weise überprüft werden kann, ob die hochpräzise Mikrostruktur nach dem mehrstufigen Ätzvorgang die erforderliche Genauigkeit aufweist.

Dieses technische Problem ist erfindungsgemäß dadurch gelöst, daß auf den Ätzmasken ein Strichmuster angebracht ist und sich die Strichmuster auf den Ätzmasken für verschiedene Ätzstufen derart unterschieden, daß sie ein Noniussystem bilden.

Bei der Anwendung dieser Lösung wird auf dem geätzten Substrat ein Strichmuster geätzt, an welchem eine Abweichung und ggf. deren Größe direkt abgelesen werden kann.

Die Erfindung ist nachstehend anhand eines in den Figuren 1 bis 3 gezeigten Ausführungsbeispieles für einen zweistufigen Ätzvorgang erläutert. Es zeigen:
- Fig. 1: den Ausschnitt aus einem in einem zweistufigen Ätzvorgang hergestellten Substrat,
- Fig. 2: die auf den beiden Ätzmasken verwendeten Strichmuster und
- Fig. 3: die von den Ätzmasken auf dem Substrat erzeugten geätzten Strichmuster.

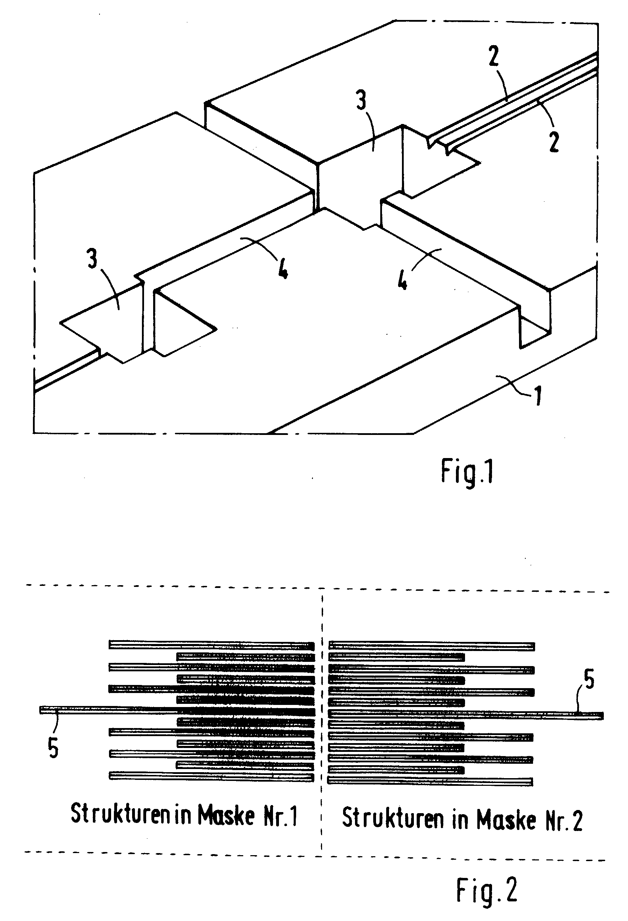

In Fig. 1 ist der Ausschnitt aus einem Substrat 1 zu erkennen, in dem durch Ätzen Vertiefungen unterschiedlicher Gestalt und unterschiedlicher Tiefe erzeugt worden sind. Es sind die verhältnismäßig flachen Rinnen 2, die kastenförmigen Vertiefungen 3 und die Gräben 4 zu erkennen. Derartige Substrate werden beispielsweise als mikrooptische Montagebank bei der Herstellung von optoelektronischen Bauelementen verwendet. In einem solchen Anwendungsfall besteht das Substrat aus Silizium. Die Erfindung kann aber bei der Herstellung anderer Gegenstände durch mehrstufiges Ätzen angewandt werden, um die Qualität der Bearbeitung zu überprüfen.- Bekanntlich wird eine Vielzahl von Präzisionsbauteilen durch Formätzen hergestellt.

Fig. 2 zeigt die Strichmuster von zwei Ätzmasken, wie sie bei einem zweistufen Ätzvorgang verwendet werden. Das linke Strichmuster ist für die Maske für den ersten Ätzvorgang vorgesehen, die Mittellinien der Striche weisen einen Abstand a auf. Das rechte Strichmuster ist für die Maske für den zweiten Ätzvorgang vorgesehen; die Mittellinien der Striche weisen einen Abstand a + x, beispielsweise a + 0,5 µm auf.

Wie aus Fig. 2 zu erkennen ist, fluchten die langen Striche 5 beider Strichmuster miteinander. Wenn das auch für das geätzte Strichmuster auf dem Substrat zutreffen würde, dann wäre zwischen beiden Ätzvorgängen keine Abweichung vorhanden. Wenn dagegen zwei mittel lange oder kurze geätzte Strichmuster auf dem Substrat miteinander fluchten, dann weichen die beiden Ätzvorgänge um 0,5 µm oder ein Mehrfaches davon voneinander ab.

Bei dem gezeigten Ausführungsbeispiel weisen die Teilstriche des Strichmusters beispielsweise einen Abstand von 40 µm (1. Maske) oder 40,5 µm (2. Maske) auf. Die Breite der Striche beträgt 20 µm und ihre Länge beträgt 50,75 und 100 µm.

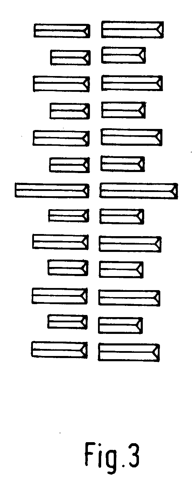

Fig. 3 zeigt die geätzten Strichmuster auf dem Substrat.

## Patentansprüche

1. Verfahren zur Kontrolle der Genauigkeit des Bearbeitungsergebnisses bei der Herstellung von Vertiefungen in einem Substrat durch mehrstufiges Ätzen, **dadurch gekennzeichnet**, daß auf den Ätzmasken ein Strichmuster angebracht ist und sich die Strichmuster auf den Ätzmasken für verschiedene Ätzstufen derart unterscheiden, daß sie ein Noniussystem bilden.

2. Durch mehrstufiges Ätzen mit Vertiefungen versehenes Substrat, dadurch gekennzeichnet, daß auf ihm mehrere geätzte Strichmuster vorhanden sind.
